# EUROPÄISCHE PATENTSCHRIFT

(11) **EP 1 438 755 B1**
(45) Veröffentlichungstag und Bekanntmachung des Hinweises auf die Patenterteilung: **26.01.2005**
(21) Anmeldenummer: 02779161.5
(22) Anmeldetag: 15.10.2002
(51) Int. Cl.: H01L 43/06

(54) **VERTIKALER HALL-SENSOR**
VERTICAL HALL SENSOR
CAPTEUR VERTICAL A EFFET HALL

(30) Priorität: 16.10.2001 DE 10150955
(43) Veröffentlichungstag der Anmeldung: 21.07.2004
(73) Patentinhaber: Fraunhofer-Gesellschaft zur Förderung der angewandten Forschung e.V., 80686 München (DE)
(72) Erfinder: HACKNER, Michael, 92331 Parsberg (DE); ERNST, Roland, 91052 Erlangen (DE); HOHE, Hans-Peter, 91332 Heiligenstadt (DE)
(74) Vertreter: Gagel, Roland, Dr.
(86) Internationale Anmeldenummer: PCT/DE2002/003901
(87) Internationale Veröffentlichungsnummer: WO 2003/036733

(56) Entgegenhaltungen:
- EP-A- 0 244 577
- WO-A-01/18556
- ERNST R ET AL: "Realising highly symmetric vertical Hall sensor elements on a standard CMOS process" EUROSENSORS XVI, 16TH EUROPEAN CONFERENCE ON SOLID-STATE TRANSDUCERS, PRAGUE, CZECH REPUBLIC, 15. - 18. September 2002, Seiten 329-330, XP009016535
- SCHURIG E ET AL: "CMOS integrated vertical Hall sensor with low offset" EUROSENSORS XVI, 16TH EUROPEAN CONFERENCE ON SOLID-STATE TRANSDUCERS, PRAGUE, CZECH REPUBLIC, 15. - 18. September 2002, Seiten 868-871, XP002241233

## Beschreibung

Die vorliegende Erfindung betrifft einen vertikalen Hall-Sensor, bei dem sich ein erstes elektrisch leitfähiges Gebiet zur Bildung eines ersten Hall-Sensorelementes senkrecht zur Oberfläche eines Substrates in das Substrat erstreckt und mehrere Anschlussbereiche entlang einer Seitenfläche an der Oberfläche des Substrates aufweist.

In vielen technischen Bereichen ist es erforderlich, die Stellung von Schaltern oder Stellgliedern berührungslos und damit verschleißfrei zu erfassen. Der Einsatz und die räumliche Erfassung von Magnetfeldern bietet in diesem Bereich Vorteile gegenüber einer optischen Erfassung, da auf Magnetfeldern basierende Techniken im Gegensatz zu optischen Verfahren wesentlich unempfindlicher gegenüber Verschmutzungen sind.
Für die räumliche Erfassung von Magnetfeldern werden Magnetfeld-Sensoren wie bspw. Hall-Sensoren eingesetzt. Derartige Sensoren lassen sich selbstverständlich für andere Anwendungsbereiche, bspw. in einem elektronischen Kompass ohne mechanische Komponenten, verwenden.

Integrierte Magnetfeld-Sensoren auf Halbleiter-Basis, die den Hall-Effekt nutzen, sind in der Literatur und der Sensor-Industrie hinreichend bekannt. Ein Hall-Sensor besteht in der Regel aus einem elektrisch leitfähigen, plattenförmigen Gebiet, das über vier Kontaktelektroden mit einer externen Ansteuerschaltung verbunden ist. Von den vier Kontaktelektroden eines Hall-Sensors werden zwei als Steuerstrom-Kontaktelektroden zur Erzeugung eines Stromflusses durch das elektrisch leitfähige Gebiet und zwei als Mess-Kontaktelektroden zur Erfassung der Hall-Spannung genutzt, die bei einem anliegenden Magnetfeld senkrecht zur Richtung des Stromflusses in dem elektrisch leitfähigen Gebiet entsteht.
Bei in CMOS-Technik realisierten Hall-Sensoren besteht das elektrisch leitfähige Gebiet in der Regel aus einem n-dotierten aktiven Halbleiterbereich auf bzw. in einem p-dotierten Halbleitersubstrat.

Bei CMOS-Prozessen zur Herstellung von Halbleiterstrukturen treten produktionsbedingt häufig Inhomogenitäten oder Störungen in dem Halbleitermaterial des aktiven Bereichs auf. Diese Inhomogenitäten lassen sich auch mit aufwendigen Herstellungsverfahren nicht vollständig vermeiden. Aufgrund der Inhomogenitäten und anderer materialbedingter Effekte tritt bei bekannten Hall-Sensoren ein unerwünschter Offset des Sensorsignals auf. Dieser Offset führt zum Auftreten eines Sensorsignals auch dann, wenn kein Magnetfeld an dem elektrisch leitfähigen bzw. aktiven Gebiet anliegt.

### Stand der Technik

Aus dem Stand der Technik ist es im Zusammenhang mit dem Einsatz von lateralen Hall-Sensoren bekannt, den Offset des Sensorsignals durch Einsatz des sog. Spinning-Current-Verfahrens zu verringern bzw. vollständig zu unterdrücken. Das Spinning-Current-Verfahren besteht darin, die Messrichtung am Hall-Sensor ständig mit einer bestimmten Taktfrequenz um bspw. 90° zyklisch weiter zu drehen und über alle Messsignale einer vollen Drehung um 360° zu summieren. Bei einem lateralen Hall-Sensor mit vier Kontaktelektroden, von denen sich jeweils zwei gegenüber liegen, wird daher jede der Kontaktelektroden je nach Spinning-Current-Phase sowohl als Steuerstrom-Kontaktelektrode als auch als Mess-Kontaktelektrode zur Abnahme des Hall-Signals genutzt. So fließt in einer Phase bzw. einem Zyklus der Steuerstrom von einer zu der gegenüber liegenden Kontaktelektrode, wobei die Hall-Spannung an den quer dazu liegenden Kontaktelektroden abgegriffen wird. Beim nächsten Zyklus wird dann die Messrichtung um 90° weiter gedreht, so dass die Kontaktelektroden, die im vorangehenden Zyklus zur Abnahme der Hall-Spannung eingesetzt wurden, nunmehr zur Einspeisung des Steuerstroms dienen. Durch die Summation über alle vier Zyklen bzw. Phasen heben sich die Offset-Spannungen annähernd gegenseitig auf, so dass nur die tatsächlich magnetfeldabhängigen Anteile des Signals übrig bleiben. Voraussetzung hierfür ist jedoch eine möglichst symmetrische Anordnung der Kontaktelektroden, wie dies bei lateralen Hall-Sensoren möglich ist. Laterale Hall-Sensoren, bei denen sich der elektrisch leitfähige Bereich parallel zur Oberfläche eines Halbleitersubstrates erstreckt, eignen sich allerdings nur zur Messung von Magnetfeldkomponenten, die senkrecht zu dieser Oberfläche gerichtet sind.

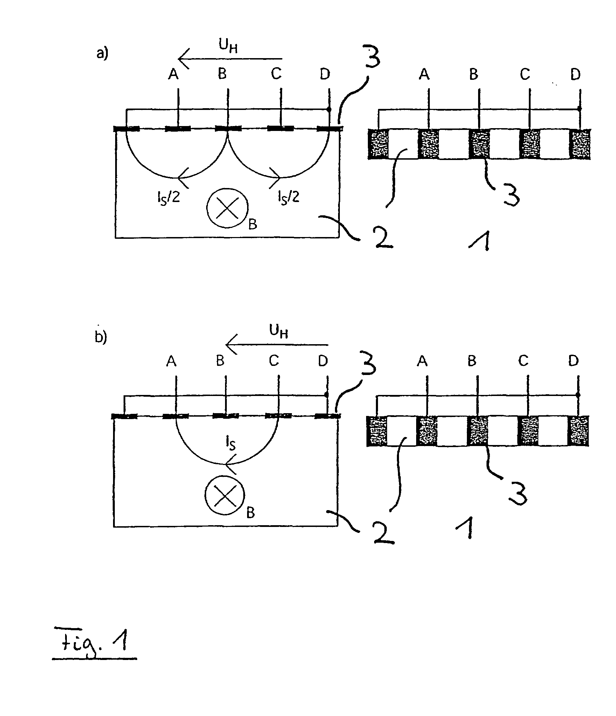

Zur räumlichen Erfassung eines Magnetfeldes werden jedoch auch Sensoren benötigt, die für Feld-Komponenten in den beiden Raumrichtungen parallel zur SubstratOberfläche empfindlich sind. Für die Realisierung dieser so genannten vertikalen Hall-Sensoren sind Lösungen bekannt, die den Einsatz von Standard-Halbleitertechnologien zu deren Herstellung ermöglichen. Ein Beispiel ist der von Popovic und Baltes vorgeschlagene vertikale Hall-Sensor, wie er ; bspw. aus dem Buch "Rotary Switch and Current Monitor by Hall-Based Microsystems" der Autoren Ralph Steiner Vanha, Verlag: Physical Electronics Laboratory, Swiss Federal Institute of Technology (ETH) Zürich, 1999, Seiten 39 - 46, bekannt ist. Bei diesem vertikalen Hall-Sensor, der durch konforme Abbildung aus bekannten Geometrien lateraler Hall-Sensoren erhalten wird, erstreckt sich ein elektrisch leitfähiges Gebiet annähernd senkrecht zur Oberfläche eines Substrates in dieses hinein, wobei sämtliche Anschlussbereiche entlang einer Seitenfläche des elektrisch leitfähigen Gebietes an der Oberfläche des Substrates liegen. Figur 1 zeigt schematisch den Aufbau dieses vertikalen Hall-Sensors.
Bei einem derartigen vertikalen, integrierten Hall-Sensor ist allerdings ein symmetrischer Aufbau nicht mehr möglich, da nur die Oberfläche des Substrates, in der Regel eines Halbleiter-Chips, für die Anschlussbereiche bzw. Kontaktelektroden zur Verfügung steht. Beim Betrieb des Hall-Sensors mit der Spinning-Current-Technik unterscheiden sich die Steuerstromverteilungen in dem elektrisch leitfähigen Gebiet für die einzelnen Spinning-Current-Phasen deutlich, so dass sehr unterschiedliche Empfindlichkeiten des Hall-Sensors in den einzelnen Phasen auftreten. Der resultierende Offset der einzelnen Phasen lässt sich daher nicht so gut kompensieren wie bei einem lateralen Hall-Sensor.

Zur Verbesserung der Offset-Kompensation ist es bekannt, die in den einzelnen Spinning-Current-Phasen erfassten Hall-Spannungen durch eine geeignete vorzeichenrichtige und gewichtete Summierung oder Subtraktion auszuwerten, um auf diese Weise den in den einzelnen Phasen enthaltenen Offset weiter zu reduzieren. Diese Zusatzauswertung ist jedoch aufwendig und erfordert für jeden einzelnen Hall-Sensor einen Kalibrier-Zyklus, da die erforderliche Gewichtung von Sensorelement zu Sensorelement schwankt und deshalb erst durch Messung bestimmt werden muss.

Ausgehend von diesem Stand der Technik besteht die Aufgabe der vorliegenden Erfindung darin, einen vertikalen Hall-Sensor anzugeben, der bei einem Spinning-Current-Betrieb einen deutlich reduzierten Offset ohne Gewichtung der einzelnen Spinning-Current-Phasen aufweist.

### Darstellung der Erfindung

Die Aufgabe wird mit dem vertikalen Hall-Sensor gemäß Patentanspruch 1 gelöst. Vorteilhafte Ausgestaltungen des Hall-Sensors sind Gegenstand der Unteransprüche.

Der vorgeschlagene vertikale Hall-Sensor, bei dem sich ein erstes elektrisch leitfähiges Gebiet zur Bildung eines ersten Hall-Sensorelementes senkrecht zur Oberfläche eines Substrates in das Substrat erstreckt und mehrere Anschlussbereiche entlang einer Seitenfläche an der Oberfläche des Substrates aufweist, zeichnet sich dadurch aus, dass zumindest ein zweites, gleichartiges Hall-Sensorelement parallel zum ersten Hall-Sensorelement im Substrat angeordnet und derart mit dem ersten Hall-Sensorelement verschaltet ist, dass beim Betrieb des Hall-Sensors mit einer Spinning-Current-Technik in jeder Spinning-Current-Phase die gleiche Kombination von Steuerstromverteilungen im Hall-Sensor erhalten wird.

Durch diese Anordnung zumindest eines weiteren Hall-Sensorelementes parallel zum ersten Hall-Sensorelement und die geeignete Verschaltung der beiden Elemente wird eine deutliche Verbesserung der Symmetrie des Hall-Sensors und der einzelnen Spinning-Current-Phasen erreicht. Durch die Erhöhung der Symmetrie wird der Unterschied in der Hall-Empfindlichkeit der einzelnen Spinning-Current-Phasen deutlich reduziert oder eliminiert, so dass eine anschließende Gewichtung der einzelnen Messwerte für eine Verringerung des Offset-Signals nicht mehr erforderlich ist.

Der vorliegende Hall-Sensor lässt sich insbesondere sehr gut mit Hall-Sensorelementen wie die in der Beschreibungseinleitung angeführten von Popovic und Baltes einsetzen, bei denen an der Oberfläche des Substrates fünf Anschlussbereiche in einer Reihe angeordnet sind. Die beiden äußersten Anschlussbereiche sind dabei elektrisch leitend miteinander verbunden. Die auf diese Weise gebildeten vier getrennten Anschlüsse werden mit den in gleicher Weise gebildeten vier Anschlüssen des zweiten Hall-Sensorelementes verschaltet. Die Verschaltung erfolgt durch Verbinden eines Anschlusses des ersten Hall-Sensorelementes mit dem jeweils in der Reihe vorangehenden oder nachfolgenden des zweiten Hall-Sensorelementes. Die weiteren-Anschlüsse werden in gleicher Weise bzw. Richtung wie der erste Anschluss miteinander verbunden. Durch dieses zyklische Vertauschen bei der Verbindung der Anschlüsse der beiden Hall-Sensorelemente wird ein elektrisch symmetrischer Hall-Sensor gebildet. Das Ergebnis ist eine Parallelschaltung von in diesem Fall zwei Hall-Sensorelementen, die elektrisch um 90° zueinander gedreht sind. Selbstverständlich muss bei der Verschaltung darauf geachtet werden, dass die bei der Messung zu erfassende Hall-Spannung durch die Verschaltung nicht kompensiert wird.

Vorzugsweise werden bei einem vertikalen Hall-Sensor mit vier Anschlüssen - entsprechend vier möglichen Spinning-Current-Phasen - insgesamt vier zueinander parallele Hall-Sensorelemente eingesetzt, die entsprechend verschaltet werden, um in jeder Spinning-Current-Phase die gleiche Kombination der Steuerstromverteilungen und der Steuerstromrichtungen zu erhalten. Bei einer derartigen Kombination von vier Hall-Sensorelementen mit jeweils vier Anschlüssen zu einem vertikalen Hall-Sensor sind alle Spinning-Current-Phasen - abgesehen von Fertigungstoleranzen der Einzel-Elemente - elektrisch identisch, da alle Anschlussbereiche bzw. Kontakte der vier Hall-Sensorelemente zu insgesamt vier elektrisch identischen Anschlüssen zusammengefasst sind.
Durch diese Kombination von vier Hall-Sensorelementen wird sichergestellt, dass in jeder Spinning-Current-Phase jedes Hall-Sensorelement mit einer anderen Phase betrieben wird und sich jeder an den zusammengefassten Anschlüssen abgegriffene Messwert elektrisch aus allen vier Spinning-Current-Phasen gleichzeitig zusammen setzt. Dies entspricht der maximal möglichen elektrischen Symmetrie des Hall-Sensors, so dass alle vier Spinning-Current-Phasen im Gegensatz zum bekannten Hall-Sensor mit nur einem Hall-Element gleichwertig gewichtet werden können. Eine Skalierung oder Kalibrierung der einzelnen Phasen ist dabei nicht mehr erforderlich. Durch diese Symmetrisierung wird der Unterschied in der Hall-Empfindlichkeit der Spinning-Current-Phasen vollständig eliminiert, so dass eine Gewichtung der Messwerte zur Offset-Korrektur nicht mehr erforderlich ist.

Auch wenn die vorliegende Erfindung in der vorangegangenen Beschreibung anhand von Hall-Sensorelementen mit fünf Anschlussbereichen und vier Anschlüssen erläutert wurde, bei denen insgesamt vier Phasen des Spinning-Current möglich sind, so ist der vorliegende vertikale Hall-Sensor selbstverständlich auch mit Hall-Sensorelementen realisierbar, die mehr als vier Anschlüsse aufweisen. Verallgemeinert gilt hierbei, dass bei Einsatz von Hall-Sensorelementen, die sich mit n Spinning-Current-Phasen betreiben lassen, zumindest eine Anzahl von n/2 derartiger Hall-Sensorelemente parallel nebeneinander angeordnet und entsprechend miteinander verschaltet sein müssen, um für jede Spinning-Current-Phase die gleiche Kombination von Steuerstromverteilungen im Gesamtelement, d. h. dem Hall-Sensor, zu erreichen. Vorzugsweise werden hierzu jedoch n Hall-Sensorelemente eingesetzt, so dass in jeder Spinning-Current-Phase nicht nur die gleichen Steuerstromverteilungen sondern auch die gleichen Steuerstromrichtungen im Hall-Sensor vorliegen.

Der vorgeschlagene vertikale Hall-Sensor wird vorzugsweise in CMOS-Technologie realisiert, wobei die elektrisch leitfähigen Gebiete als n-dotierte Halbleiterbereiche in einem p-dotierten Halbleiterchip ausgebildet sein können.

### Kurze Beschreibung der Zeichnungen

Der vorliegende vertikale Hall-Sensor wird nachfolgend anhand von Ausführungsbeispielen in Verbindung mit den Zeichnungen nochmals kurz erläutert. Hierbei zeigen:
- Fig. 1: ein Beispiel für einen vertikalen Hall-Sensor des Standes der Technik sowie der zugehörigen Steuerstromverteilungen in zwei Spinning-Current-Phasen;
- Fig. 2: ein erstes Beispiel für den Aufbau des vorliegenden vertikalen Hall-Sensors in Draufsicht; und
- Fig. 3: ein zweites Beispiel für den Aufbau des vorliegenden vertikalen Hall-Sensors in Draufsicht.

### Wege zur Ausführung der Erfindung

Figur 1 zeigt ein Beispiel für den Aufbau eines bekannten vertikalen Hall-Sensors, wie er von Popovic und Baltes vorgeschlagen wurde. In Figur 1a ist hierbei im linken Teil eine Seitenansicht des Hall-Sensors parallel zur Oberfläche des Halbleiter-Chips, in dem der Sensor integriert ist, dargestellt. Die Figur zeigt das elektrisch leitfähige Gebiet 2, das sich senkrecht zur Oberfläche des Chips 1 in diesen Chip erstreckt. Das elektrisch leitfähige Gebiet 2 ist plattenförmig ausgebildet, so dass seine Länge und Tiefe, die im linken Teil der Figur 1a zu erkennen sind, deutlich größer als seine im rechten Teil der Figur erkennbare Breite sind. Dies entspricht der typischen Ausgestaltung des elektrisch leitfähigen Gebietes eines Hall-Sensorelementes. Selbstverständlich kann die Breite des elektrisch leitfähigen Gebietes eines Hall-Sensors für dessen Funktion auch größer als die Länge und Tiefe ausfallen.
In der Figur sind weiterhin die elektrischen Anschlussbereiche 3 entlang der Seitenfläche des elektrisch leitfähigen Gebietes 2 an der Oberfläche des Chips 1 zu erkennen. Die beiden äußeren Anschlussbereiche sind elektrisch leitend miteinander verbunden und bilden einen gemeinsamen äußeren Anschluss D. Die weiteren Anschlussbereiche bilden entsprechend ihrer Reihenfolge die elektrischen Anschlüsse A, B und C. Der gesamte Hall-Sensor, der sich nur aus einem einzelnen Hall-Sensorelement zusammen setzt, ist im rechten Teil der Figur 1a nochmals in Draufsicht, d. h. senkrecht auf die Chip-Oberfläche, zu erkennen. In dieser Darstellung sind insbesondere die entlang der Seitenfläche des elektrisch leitfähigen Gebietes 2 ausgebildeten Anschlussbereiche 3 zu erkennen, die insgesamt zu den vier Anschlüssen A - D des Hall-Sensors zusammengefasst sind.

Beim Betrieb dieses bekannten vertikalen Hall-Sensors mit einer Spinning-Current-Technik wird in einer ersten Spinning-Current-Phase durch Anlegen einer Steuerspannung zwischen den Anschlüssen D und B ein Steuerstrom I_{S} erzeugt, der in dem elektrisch leitfähigen Gebiet 2 eine Steuerstromverteilung entsprechend der schematischen Darstellung der Figur 1a ergibt. Hierbei fließt jeweils ein Steuerstrom der Größe I_{S}/2 vom Anschluss B zu den beiden Anschlussbereichen des Anschlusses D. Bei Vorliegen eines magnetischen Feldes B parallel zur Chip-Oberfläche, wie dies ebenfalls in der Figur 1a schematisch dargestellt ist, entsteht eine Hall-Spannung U_{H} zwischen den Anschlüssen C und A, die mit dem Pfeil angedeutet ist. Durch Abgreifen der beiden Anschlüsse A und C kann die Hall-Spannung U_{H} gemessen und daraus die Größe des Magnetfeldes B berechnet werden.

In der nächsten Spinning-Current-Phase wird der Steuerstrom zwischen den beiden Anschlüssen A und C angelegt, wobei ein Steuerstrom I_{S} zwischen diesen beiden Anschlüssen durch das elektrisch leitfähige Gebiet 2 fließt, wie dies im linken Teil der Figur 1b angedeutet ist. Die Figur 1b zeigt die gleiche Anordnung in Seitenansicht (links) und Draufsicht (rechts) wie die Figur 1a, jedoch beim Betrieb mit einer anderen Spinning-Current-Phase. Die unterschiedliche Steuerstromverteilung im elektrisch leitfähigen Gebiet 2 in den beiden unterschiedlichen Spinning-Current-Phasen ist aus den Figuren 1a und 1b deutlich zu erkennen. Die beiden verbleibenden Spinning-Current-Phasen ergeben sich analog aus den beiden ersten Phasen durch Umkehrung der Strom- und Spannungs-Richtungen.
Durch diese unterschiedliche Verteilung des Steuerstroms kommt es zu unterschiedlichen Sensor-Empfindlichkeiten in den einzelnen Phasen und der resultierende Offset der Phasen lässt sich nicht mehr gut kompensieren.

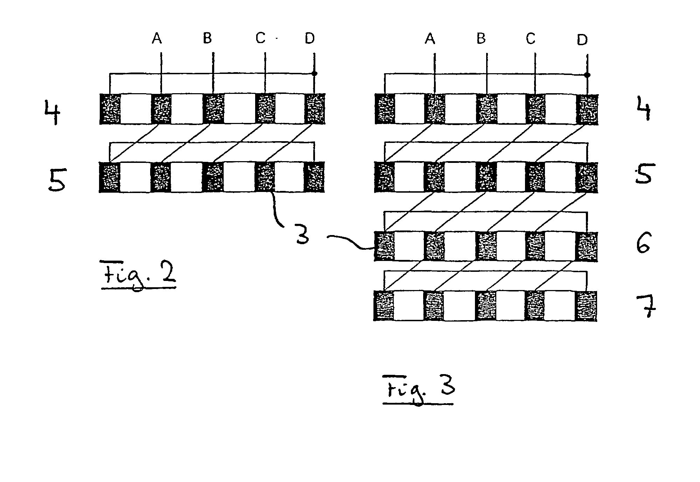

Zur Verbesserung der Kompensation des Offsets eines derartigen vertikalen Hall-Sensors wird erfindungsgemäß ein Hall-Sensor vorgeschlagen, der zumindest ein zweites Hall-Sensorelement 5 parallel zum ersten Hall-Sensorelement 4 aufweist. Beide Hall-Elemente 4, 5 sind dabei zu einem symmetrisierten Element verschaltet. In der Figur 2 ist in Draufsicht eine derartige Verschaltung zu erkennen, die zu einer deutlichen Reduzierung des gemessenen Offsets führt. Die Figur 2 zeigt in Draufsicht zwei Seitenflächen elektrisch leitfähiger Gebiete 2, die sich senkrecht in ein Halbleiter-Substrat 1, insbesondere einen Halbleiter-Chip, erstrecken. Entlang dieser Seitenflächen sind bei jedem der Hall-Sensorelemente 4, 5 fünf Anschlussbereiche 3 ausgebildet, von denen jeweils die äußersten elektrisch leitfähig miteinander verbunden sind. Das erste Hall-Sensorelement 4 entspricht hierbei im Aufbau exakt dem Hall-Sensorelement der Figur 1 und weist entsprechend die vier Anschlüsse A - D auf. Das zweite Hall-Sensorelement 5 ist identisch aufgebaut und derart mit dem ersten Hall-Sensorelement 4 verschaltet, dass in jeder Spinning-Current-Phase immer die Kombination der beiden in den Figuren 1a und 1b dargestellten Steuerstromverteilungen in den beiden Hall-Sensorelementen 4 und 5 auftritt. Dies wird durch zyklisches Vertauschen der Anschlüsse in diesem Beispiel in folgender Weise erreicht. Anschluss A des Hall-Sensorelementes 4 wird mit Anschluss D des Hall-Sensorelementes 5 verbunden. Anschluss B des Hall-Sensorelementes 4 wird mit Anschluss A des Hall-Sensorelementes 5 verbunden. Anschluss C des Hall-Sensorelementes 4 wird mit Anschluss B des Hall-Sensorelementes 5 verbunden und Anschluss D des Hall-Sensorelementes 4 wird mit Anschluss C des Hall-Sensorelementes 5 verbunden. Das Ergebnis ist eine Parallelschaltung zweier Hall-Sensorelemente 4, 5, die elektrisch um 90° zueinander gedreht sind.

Das gleiche Ergebnis wird mit einer Verschaltung erreicht, bei dem die Anschlüsse A, B, C und D des Hall-Sensorelementes 4 mit den Anschlüssen B, C, D bzw. A des Hall-Sensorelementes 5 verschaltet werden. Eine andere Verschaltung ist in diesem Falle nicht möglich, da dann zwar ebenfalls eine Symmetrisierung erreicht werden kann, sich die in den beiden Hall-Sensorelementen erhaltenen Hall-Spannungen jedoch gegenseitig kompensieren würden, so dass insgesamt keine magnetische Empfindlichkeit des Hall-Sensors mehr feststellbar wäre.

Figur 3 zeigt schließlich ein weiteres Beispiel für die Ausgestaltung des vorliegenden vertikalen Hall-Sensors, bei dem die Symmetrie noch weiter verbessert ist. In diesem Beispiel werden vier Hall-Sensorelemente 4, 5, 6 und 7 in einer Weise miteinander verschaltet, wie sie aus der Figur 3 und der nachfolgenden Tabelle ersichtlich ist. Bei dieser Kombination sind alle Spinning-Current-Phasen sowohl hinsichtlich der Steuerstromverteilungen als auch hinsichtlich der Steuerstromrichtungen elektrisch identisch.

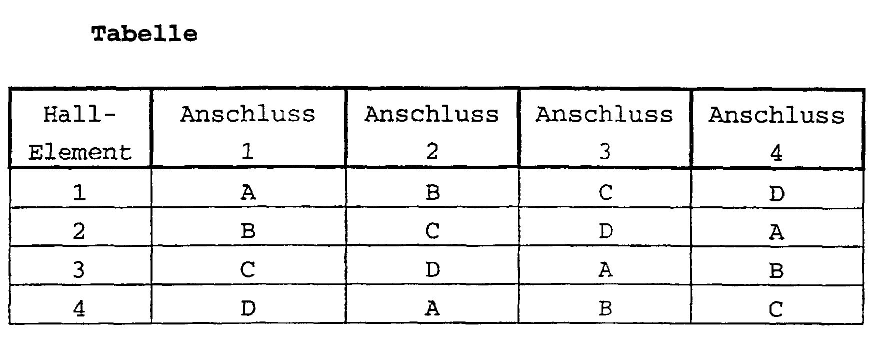

Durch diese Verschaltung von vier Einzel-Hall-Sensorelementen zu einem symmetrischen Hall-Sensor wird sichergestellt, dass in jedem Fall bzw. in jeder Phase jeder der vier möglichen Strom-Pfade des Spinning-Current-Betriebes in je einem Einzel-Hall-Sensorelement gebildet wird. Das bedeutet, dass sich die vier Phasen nicht mehr unterscheiden lassen, sofern sich die Einzel-Hall-Sensorelemente in ihren elektrischen und magnetischen Eigenschaften nicht zu stark unterscheiden.

### Bezugszeichenliste

- 1: Substrat bzw. Halbleiterchip
- 2: elektrisch leitfähiges Gebiet
- 3: Anschlussbereiche
- 4: erstes Hall-Sensorelement
- 5: zweites Hall-Sensorelement
- 6: drittes Hall-Sensorelement
- 7: viertes Hall-Sensorelement
- A - D: Anschlüsse der Hall-Elemente

## Patentansprüche

1. Vertikaler Hall-Sensor, bei dem sich ein erstes elektrisch leitfähiges Gebiet (2) zur Bildung eines ersten Hall-Sensorelementes (4) senkrecht zur Oberfläche eines Substrates (1) in das Substrat (1) erstreckt und mehrere Anschlussbereiche (3) entlang einer Seitenfläche an der Oberfläche des Substrates (1) aufweist,
**dadurch gekennzeichnet,**
**dass** zumindest ein zweites, identisch aufgebautes Hall-Sensorelement (5) parallel zum ersten Hall-Sensorelement (4) im Substrat (1) angeordnet und derart mit dem ersten Hall-Sensorelement (4) verschaltet ist, dass beim Betrieb des Hall-Sensors mit einer Spinning-Current-Technik in jeder Spinning-Current-Phase die gleiche Kombination von Steuerstromverteilungen im Hall-Sensor erhalten wird.

2. Vertikaler Hall-Sensor nach Anspruch 1,
**dadurch gekennzeichnet,**
**dass** die Verschaltung des zweiten (5) mit dem ersten Hall-Sensorelement (4) derart ausgeführt ist, dass jeder Anschlussbereich (3) des ersten Hall-Sensorelementes (4) mit einem in der Reihenfolge vorangehenden oder nachfolgenden Anschlussbereich (3) des zweiten Hall-Sensorelementes (5) verbunden ist.

3. Vertikaler Hall-Sensor nach Anspruch 1 oder 2,
**dadurch gekennzeichnet,**
**dass** ein drittes (6) und ein viertes gleichartiges Hall-Sensorelement (7) parallel zum ersten Hall-Sensorelement (4) im Substrat (1) angeordnet und derart mit dem ersten Hall-Sensorelement (4) verschaltet sind, dass beim Betrieb des Hall-Sensors mit einer Spinning-Current-Technik in jeder Spinning-Current-Phase die gleiche Kombination von Steuerstromverteilungen und Steuerstromrichtungen im Hall-Sensor erhalten wird.

4. Vertikaler Hall-Sensor nach einem der Ansprüche 1 bis 3,
**dadurch gekennzeichnet,**
**dass** insgesamt n/2 oder n Hall-Sensorelemente (4, 5, 6, 7) für einen Betrieb des Hall-Sensors mit n Spinning-Current-Phasen parallel zueinander vorgesehen und miteinander verschaltet sind.

5. Vertikaler Hall-Sensor nach einem der Ansprüche 1 bis 4,
**dadurch gekennzeichnet,**
**dass** das Substrat (1) ein Halbleitersubstrat ist und die elektrisch leitfähigen Gebiete (2) durch dotierte Bereiche in dem Halbleitersusbtrat (1) gebildet sind.

## Claims

1. A vertical Hall sensor, in which a first electroconductive region (2) extends into a substrate (1) perpendicular to the surface of the substrate (1) in order to form a first Hall sensor element (4) and comprises several connection areas (3) along a lateral face on the surface of the substrate (1),
**characterized in**
**that** at least a second, identical Hall sensor element (5) is arranged in the substrate (1) parallel to the first Hall sensor element (4) and wired to the first Hall sensor element (4) in such a way that, when operating the Hall sensor in the spinning current mode, the same combination of control current distributions is obtained in the Hall sensor in each spinning current phase.

2. The vertical Hall sensor according to Claim 1,
**characterized in**
**that** the second Hall sensor element (5) is wired to the first Hall sensor element (4) in such a way that each connection area (3) of the first Hall sensor element (4) is connected to one sequentially preceding or following connection area (3) of the second Hall sensor element (5).

3. The vertical Hall sensor according to Claim 1 or 2,
**characterized in**
**that** a third (6) and a fourth Hall sensor element (7) of identical design are arranged in the substrate (1) parallel to the first Hall sensor element (4) and wired to the first Hall sensor element (4) in such a way that, when operating the Hall sensor in accordance with the spinning current technique, the same combination of control current distributions and control current directions is obtained in the Hall sensor in each spinning current phase.

4. The vertical Hall sensor according to one of Claims 1-3,
**characterized in**
**that** a total of n/2 or n Hall sensor elements (4, 5, 6, 7) are arranged parallel and wired to one another in order to operate a Hall sensor with n spinning current phases.

5. The vertical Hall sensor according to one of Claims 1-4,
**characterized in**
**that** the substrate (1) consists of a semiconductor substrate and the electroconductive regions (2) are formed by doped regions in the semiconductor substrate (1) .

## Revendications

1. Capteur Hall vertical, dans lequel une première région électriquement conductrice (2) pour former un premier élément de capteur Hall (4) s'étend perpendiculairement à la surface d'un substrat (1) dans le substrat (1) et présente plusieurs zones de raccordement (3) le long d'une surface latérale sur la surface du substrat (1),
**caractérisé en ce que**,
au moins un deuxième élément de capteur Hall de structure identique (5) est disposé parallèlement au premier élément de capteur Hall (4) dans le substrat (1) et il est connecté au premier élément de capteur Hall (4) de sorte que pendant le fonctionnement du capteur Hall avec une technologie de "spinning current" (à courant tournant), la même combinaison des distributions de courant de commande dans le capteur Hall est obtenue dans chaque phase à "spinning current".

2. Capteur Hall vertical selon la revendication 1,
**caractérisé en ce que**,
la connexion du deuxième élément de capteur Hall (5) avec le premier (4) est réalisée de façon à ce que chaque zone de raccordement (3) du premier élément de capteur Hall (4) est reliée à une zone de raccordement précédente ou suivante dans l'ordre, du deuxième élément de capteur Hall (5).

3. Capteur Hall vertical selon la revendication 1 ou 2,
**caractérisé en ce que**,
un troisième élément de capteur Hall (6) et un quatrième (7) de même type, sont disposés parallèlement au premier élément de capteur Hall (4) dans le substrat (1) et sont connectés au premier élément de capteur Hall (4) de sorte que pendant le fonctionnement du capteur Hall avec une technologie de "spinning current", la même combinaison de distributions de courant de commande et de directions de courant de commande dans le capteur Hall est obtenue dans chaque phase à "spinning current".

4. Capteur Hall vertical selon l'une quelconque des revendications 1 à 3,
**caractérisé en ce que**,
au total n/2 ou n éléments de capteur Hall (4, 5, 6, 7) sont prévus en parallèle les uns aux autres, pour un fonctionnement du capteur Hall avec n phases à "spinning current", et sont connectés entre eux.

5. Capteur Hall vertical selon l'une quelconque des revendications 1 à 4,
**caractérisé en ce que**,
le substrat (1) est un substrat semiconducteur, et les régions électriquement conductrices (2) sont formées par des zones dopées dans le substrat semiconducteur (1).
